# EUROPEAN PATENT APPLICATION

(11) **EP 1 881 352 A1**
(43) Date of publication of application: **23.01.2008**
(21) Application number: 07014121.3
(22) Date of filing: 18.07.2007
(51) Int. Cl.: G02B 6/42, H01S 5/022, H05K 1/18

(54) **Optical transceiver**

(30) Priority: 18.07.2006 JP 2006195508
(71) Applicant: NEC Corporation, Minato-ku Tokyo (JP)
(72) Inventor: Minota, Yuji, Minato-ku Tokyo (JP)
(74) Representative: Glawe, Delfs, Moll

(57) **Abstract**

The present invention provides an optical transceiver which can be miniaturized while having a number of electronic components mounted on an electrical circuit board thereof. An optical transceiver comprises: a substrate (41) having at least one electronic component mounted thereon; a base (50) comprising a receptacle for connecting an optical connector; and a case (21,22) which houses the substrate (41). The substrate is substantially perpendicular to an upper surface or a lower surface of the case.

## Description

### CROSS-REFERENCE TO RELATED APPLICATION

This application claims priority from Japanese Patent Application No. 2006-195508, filed on July 18, 2006, in the Japanese Patent Office, the disclosure of which is hereby incorporated by reference in its entirety.

### BACKGROUND OF THE INVENTION

### Field of the Invention

Apparatuses consistent with the present invention relate to an optical transceiver for optical communication.

### Description of the Related Art

A related art optical transceiver converts an electrical signal into an optical signal, and transmits and receives data to and from a communications device, a network device, a computer, and a storage device by using an optical fiber as a transmission line.

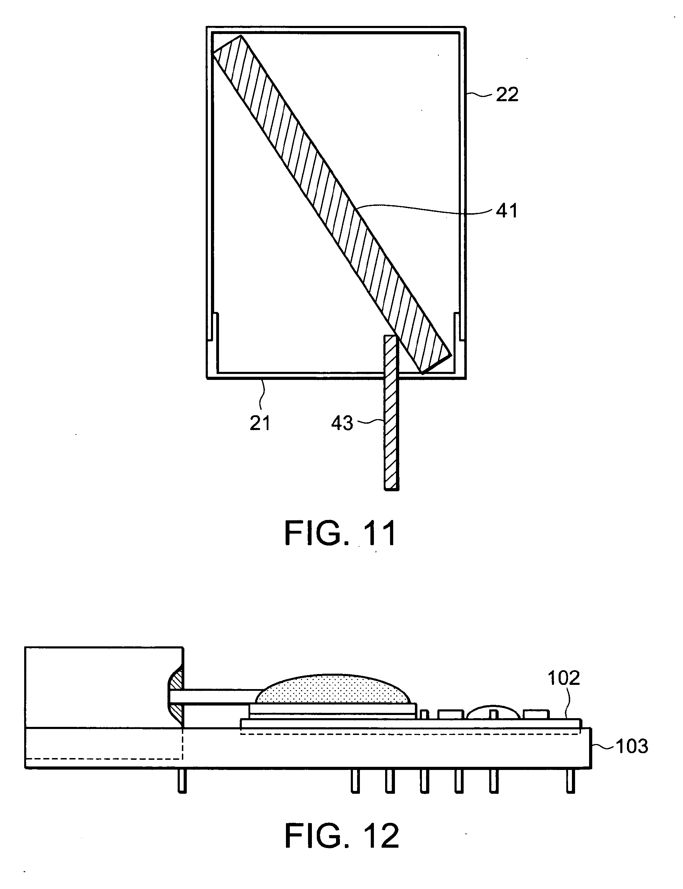

As an example of an optical transceiver in the related art, FIG 12 is a side view of an optical transmission module disclosed in Japanese Patent Laid-Open No. 2004-219763.

In FIG. 12, an electrical circuit board 102 is mounted on a plate-like base 103 having a predetermined thickness. A plurality of electronic components (not shown) are mounted on the electrical circuit board 102.

However, in FIG. 12, if it is needed to mount a large number of electronic components on the electrical circuit board 102, the electrical circuit board 102 must be large enough to mount all of those electronic components. As a result, the optical transceiver must be larger. Meanwhile, as miniaturization of the optical transceiver is required, the number of the electronic components mounted on the electrical circuit board 102 is limited.

### SUMMARY OF THE INVENTION

Exemplary embodiments of the present invention overcome the above disadvantages and other disadvantages not described above. Also, the present invention is not required to overcome the disadvantages described above, and an exemplary embodiment of the present invention may not overcome any of the problems described above.

The present invention provides an optical transceiver which can be miniaturized while having a number of electronic components mounted on the electrical circuit board thereof.

According to an aspect of the present invention, an optical transceiver comprises: a substrate having at least one electronic component mounted thereon; a base comprising a receptacle for connecting an optical connector; and a case housing the substrate. In the optical transceiver, one end of the base is housed in the case and the other end of the base is not housed in the case. The substrate may be substantially perpendicular to an upper surface or a lower surface of the case.

According to an another aspect of the present invention, an optical transceiver comprises: a substrate having at least one electronic component mounted thereon; a case housing the substrate, and a base. One end of the base which is housed in the case fixes the substrate, and a receptacle for connecting an optical connector is formed on the other end of the base which is not housed in the case. In the optical transceiver, the substrate is not parallel to at least one of the upper surface and the lower surface of the case. The substrate may be substantially perpendicular to at least one of the upper surface and the lower surface of the case. The substrate may comprise an upper edge in contact with the upper surface of the case and a lower edge in contact with the lower surface of the case.

According to an another aspect of the present invention, an optical transceiver comprises: a substrate having at least one electronic component mounted thereon; a base having a first end and a second end and a first side and a second side, the base comprising a groove formed on the first end of the base, a receptacle for connecting an optical connector formed on the second end of the base, and locking protrusions formed on the first and second sides of the base; and a case which has locking holes formed in its sides, and in which at least the substrate and a part of the base are housed. In the optical transceiver, the substrate is substantially perpendicular to at least one of an upper surface and a lower surface of the case. At least one end of the substrate is fixed to the groove in the base. The locking protrusions of the base are fixed into the locking holes of the case. The substrate is not mounted on the base. The base may be in contact with upper and lower surfaces of the case. The optical transceiver may further comprise a connection terminal connected to the substrate. The connection terminal is not inserted in said base. The base may comprise a first material and the case may comprise a second material different from the first material. The first material may be resin and the second material may be metal.

According to an another aspect of the present invention, an optical transceiver comprises: a plurality of optical units, each of which comprises a substrate having at least one electronic component mounted thereon, and a base, wherein the substrate is fixed to the first end of the base, and concave and convex portions in sides of the base. A case houses the substrate and the first end of the base, and the second end of the base is not housed in the case. In the optical transceiver, the substrate is substantially perpendicular to an upper surface or a lower surface of the case. The concave and convex portions of a base fit with the convex and concave portions of an adjacent base such that the plurality of optical units are connected to one another. At least one base has a groove in a side thereof, and that the case has at least one reinforcing means which is inserted in the groove. When the plurality of optical units are connected to one another, there may be a space between the units adjacent to the at least one groove, and the reinforcing means is inserted in the Therefore, according to an aspect of the present invention, a substrate having a large surface can be adopted by mounting the substrate in a case, but not on a base, substantially perpendicular or tilted at a predetermined angle. Thus, a number of electronic components can be mounted on the substrate, and it becomes possible to miniaturize the optical transceiver.

### BRIEF DESCRIPTION OF THE DRAWINGS

The above and other aspects of the present invention will become more apparent from the following detailed description of exemplary embodiments thereof with reference to the accompanying drawings, in which:
FIG. 1 is a perspective view showing a small form factor (SFF) transceiver according to an exemplary embodiment of the present invention;
FIG. 2 is a perspective view showing that the SFF transceiver in FIG 1 is mounted on a communications device;
FIGs. 3A to 3D form an exploded perspective view of FIG. 1;
FIGs. 4A to 4E are views showing a base in detail;
FIG. 5 is a schematic view showing a cross section along the line A-A' of the SFF transceiver shown in FIG. 1;
FIG. 6 is a perspective view of an SFF transceiver according to an exemplary embodiment of the present invention;
FIGs. 7A to 7C form an exploded perspective view of the SFF transceiver shown in FIG 6;
FIG. 8 is an enlarged view of the part A shown in FIGs. 7A to 7C;
FIG. 9 is a perspective view of an SFF transceiver according to an exemplary embodiment of the present invention;
FIGs. 10A to 10C form an exploded perspective view of the SFF transceiver shown in FIG. 9;
FIG 11 is another schematic view showing the cross section along the line A-A' shown in FIG. 1; and
FIG. 12 is a side view of a related art optical transmission module.

### DETAILED DESCRIPTION OF EXEMPLARY EMBODIMENTS OF THE PRESENT INVENTION

Exemplary embodiments of the invention will now be described below by reference to the attached Figures. The described exemplary embodiments are intended to assist the understanding of the invention, and are not intended to limit the scope of the invention in any way.

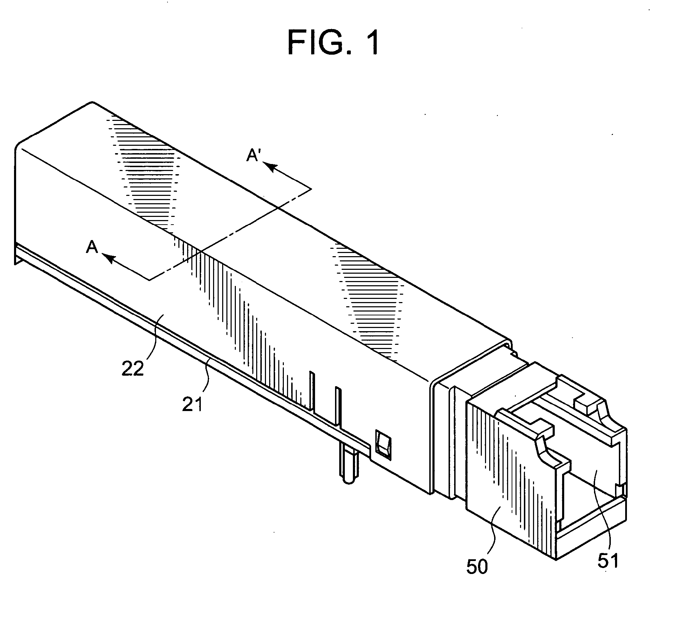

FIG. 1 is a perspective view showing a small form factor (SFF) transceiver of the exemplary embodiment of the present invention.

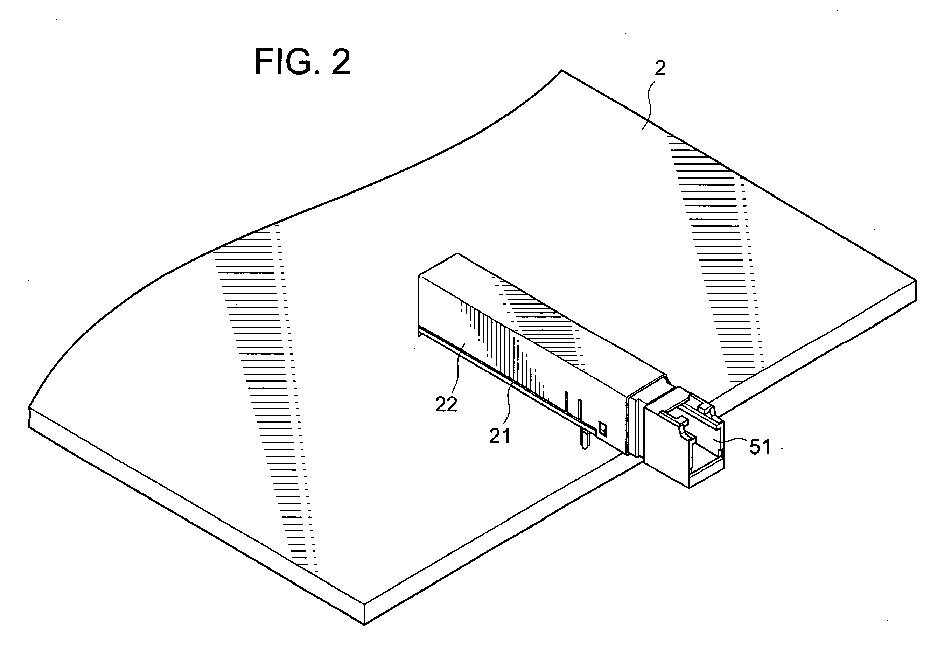

In FIG 1, the SFF transceiver has at least a case, which is formed of a base cover 21 and a main cover 22, and a base 50. In an end face of the base 50, a receptacle 51 is formed, to which an detachable optical connector (not shown) is connected. The case houses at least an optical module, a substrate and at least a part of the base 50, and does not house the receptacle 51. The SFF transceiver is mounted on a master substrate 2 included in a communications device, as shown in FIG. 2, for example.

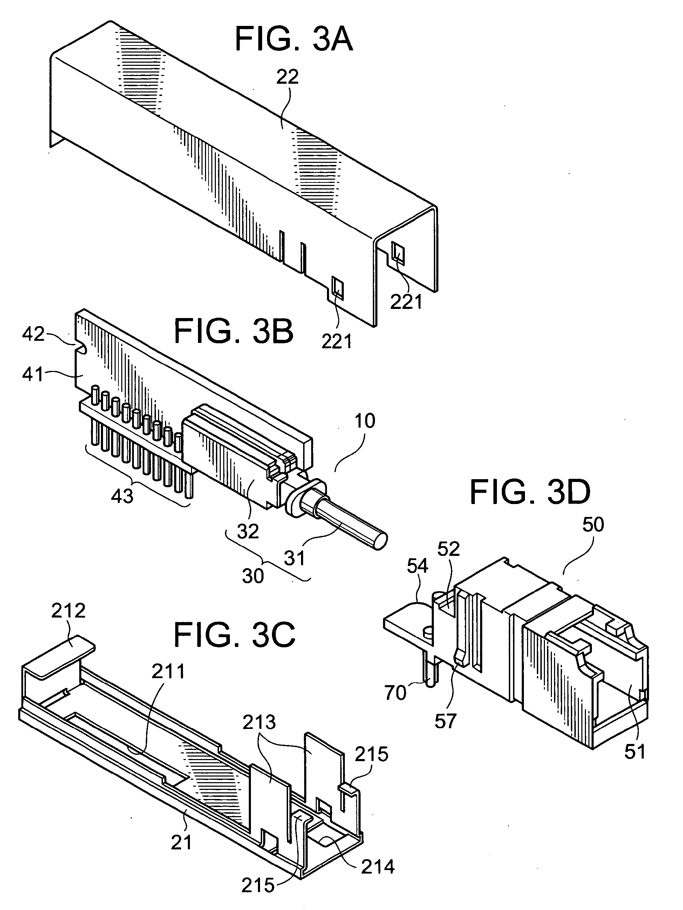

FIGs. 3A-3D form an exploded perspective view of the SFF transceiver shown in FIG 1.

In FIGs. 3A-3D, the SFF transceiver shown in FIG. 1 is formed in the following manner. An optical module assembly 10 is fixed to the base 50 (hereinafter, the fixed optical module assembly 10 and the base 50 will be referred to as an "optical unit"). The optical unit is fixed by being sandwiched between the base cover 21 and the main cover 22. Here, upper and lower surfaces of the base 50 contact with an upper surface of the main cover 22 and a lower surface of the base cover 21, respectively. Further, the base 50 is shorter than the case, and a part of the base 50, which is housed in the case, is shorter than an overall length of the case.

In the optical module assembly 10, a substrate 41 is, for example, a printed wiring board (PWB) and is positioned not in parallel to the lower surface of the base cover 21 but substantially perpendicular thereto. An optical module 30 comprises: an optical element part 32 mounted on the substrate 41; and a ferrule 31 used for optical axis alignment with an optical fiber (not shown) connected to the optical element part 32 and the receptacle 51. The optical element part 32 may comprise, for example, a laser diode (LD) as a light emitting element, a photodiode (PD) as a light receiving element, a lens and the like. Moreover, the optical module 30 may be a leadless module, to be mounted on the surface of the substrate 41.

A substrate supporting hole 42 formed in one end of the substrate 41 is connected to a substrate supporting part 212 of the base cover 21. Thus, the optical module assembly 10 is fixed to the base cover 21. Further, a connection terminal 43 connected to the substrate 41 is connected to the master substrate 2 in the communications device shown in FIG. 2. Accordingly, electrical signals are transmitted through the connection terminal 43 from the master substrate 2 to the substrate 41 or from the substrate 41 to the master substrate 2.

The base cover 21 has a connection terminal insertion hole 211, the substrate supporting part 212, a base guide part 213, a reinforcing pin insertion hole 214 and a base lock part 215. The connection terminal insertion hole 211 is a hole formed in the lower surface of the base cover 21. The connection terminal 43 of the optical module assembly 10 is inserted into the connection terminal insertion hole 211. Therefore, the connection terminal 43 does not contact with and is not inserted into the base 50. The substrate supporting part 212 is formed by bending one end of the base cover 21 and is fixed in the substrate supporting hole 42. The base guide part 213 supports both sides of the base 50 and fixes the base 50 to the base cover 21. A reinforcing pin 70 which is attached to the base 50 is inserted into the reinforcing pin insertion hole 214. The base lock part 215 locks a base cover lock part 52 in the base 50, and fixes the base 50 to the base cover 21.

The main cover 22 has locking holes 221. The locking holes 221 lock locking protrusions 57 in the base 50. Moreover, end parts of both sides of the main cover 22, i.e. peripheral portions of the locking holes 221, sandwich both sides of the base 50. Thus, the base 50 is fixed to the main cover 22.

The base cover 21 and the main cover 22 are formed by bending metal plates such as stainless steel and phosphor bronze, for example. The covers may comprise materials having a high thermal conductivity and a small thickness.

In the base 50, the base cover lock part 52 is a groove formed in a part of the base 50 and is locked with the base lock part 215 in the base cover 21. The locking protrusions 57 are protrusions formed on the both sides of the base 50, and are locked in the locking holes 221 provided in the main cover 22. A substrate supporting part 54 is a groove formed in one end of the base 50, and fixes the optical module assembly 10 to the base 50 by holding one end of the substrate 41. The substrate 41 is not mounted on the base 50.

The reinforcing pin 70 attached to one end of the base 50 is fitted into the master substrate 2 in the communications device, and fixes the base 50 or the SFF transceiver itself to the master substrate 2.

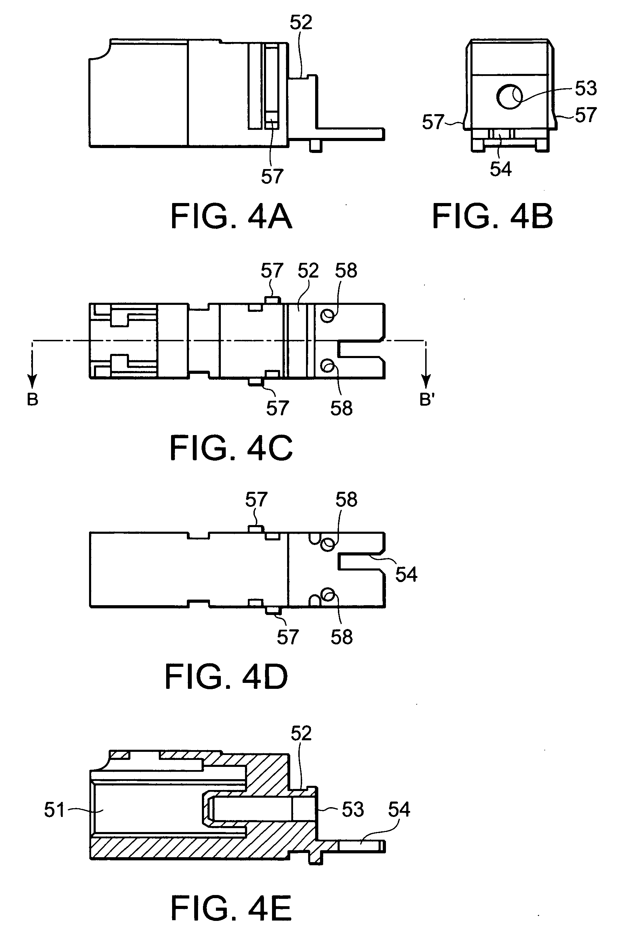

The base 50 will be described in detail with respect to FIGs. 4A to 4E.

Figs. 4A and 4B are a front view and a right side view of the base 50, respectively.

In FIG. 4B, a press fitting part 53 is a cylindrical hole. And the ferrule 31 of the optical module 30 is press-fitted into the hole and fixed.

Figs. 4C and 4D are a plan view and a bottom view of the base 50, respectively.

In Figs. 4C and 4D, the reinforcing pins 70 are inserted into reinforcing pin insertion holes 58. The substrate supporting part 54 is a substantially rectangular-shaped groove. A width of the substrate supporting part 54 may be approximately the same as a thickness of the substrate 41 so as to securely fix the substrate 41 to the base 50. The locking protrusion 57 formed on one of the sides of the base 50 and the locking protrusion 57 formed on the other side do not face each other.

FIG. 4E is a cross-sectional view along the line B-B' in the plan view of the base 50 shown in FIG. 4C.

The base 50 is formed of, for example, a metal material such as stainless steel or a resin material such as PPS (Polyphenylene Sulfide), unlike the materials of the base cover 21 and the main cover 22. Particularly, in a case where the base 50 is formed of a metal material such as stainless steel, the press fitting part 53 may be formed of a resin material.

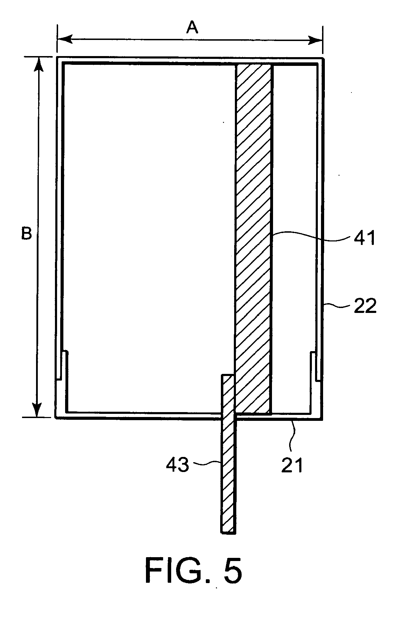

FIG. 5 is a schematic view showing a cross section along the line A-A' in FIG. 1.

In FIG. 5, the substrate 41 is positioned substantially perpendicular to the lower surface of the base cover 21. However, the substrate 41 may be positioned substantially perpendicular to the upper surface of the main cover 22 or the master substrate 2, or may be positioned substantially parallel to the side of the main cover 22. Further, the substrate 41 may be positioned at a predetermined spacing from the side of the main cover 22 so as to enable components such as various optical elements and ICs to be mounted on both sides of the substrate 41. However, depending on the number of the components, the substrate 41 may be positioned to contact with the side of the main cover 22 without the predetermined spacing. As in the case of the substrate 41, the connection terminal 43 may also be positioned substantially perpendicularly to the lower surface of the base cover 21, the upper surface of the main cover 22 or the master substrate 2, or be substantially parallel to the side of the main cover 22.

In the SFF transceiver of the exemplary embodiment of the present invention, a number of electronic components can be mounted on the substrate 41 by positioning the substrate 41 substantially perpendicular to the lower surface of the base cover 21. Moreover, a width of the SFF transceiver, which is indicated by "A" in FIG. 5, can be reduced. For example, the width of the SFF transceiver of this exemplary embodiment is 7.35 mm, which is about half the width of 13.59 mm as the width of the SFF transceiver specified in the industry standards called Multi Source Agreement (MSA). Note that, the width of the SFF transceiver of this exemplary embodiment can also be set to be half of 13.59 mm or smaller than the half by various factors, for example, by reducing heights of the electronic components mounted on the substrate 41, or by reducing the thickness of the substrate 41.

Further, the electronic components can be mounted on the both sides of the substrate 41 by positioning the substrate 41 at the predetermined space from the side of the main cover 22. Thus, a larger number of electronic components can be mounted on the substrate 41.

Furthermore, in the related art, the substrate 41 has been mounted on a thick base formed of a resin material. Meanwhile, in the SFF transceiver of this exemplary embodiment, a part of the base 50 formed of a resin material is removed, and the substrate 41 is mounted on the metal base cover 21 which is thinner than the resin material. Thus, it is possible to adopt the substrate 41 longer in a direction of a height of the SFF transceiver, which is indicated by "B" in FIG. 5. Consequently, a still larger number of components can be mounted on the substrate 41 having a larger area.

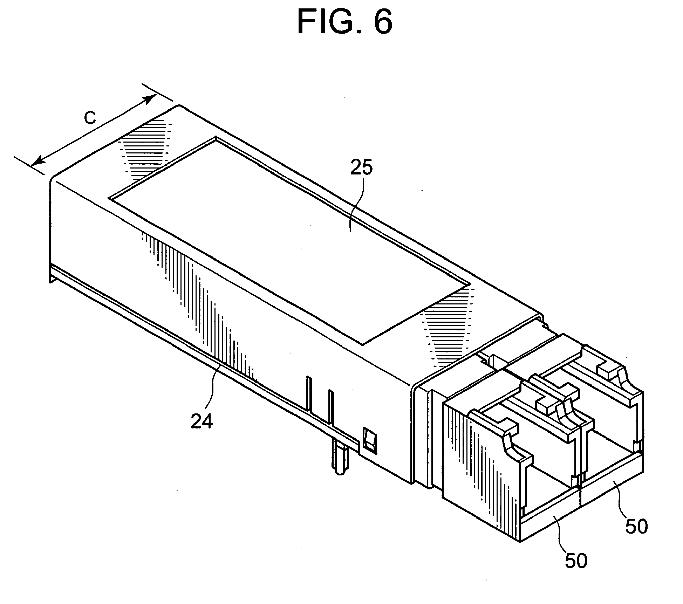

Next, another exemplary embodiment of the present invention will be described with reference to Figs. 6 to 8.

An SFF transceiver of this exemplary embodiment has two optical units.

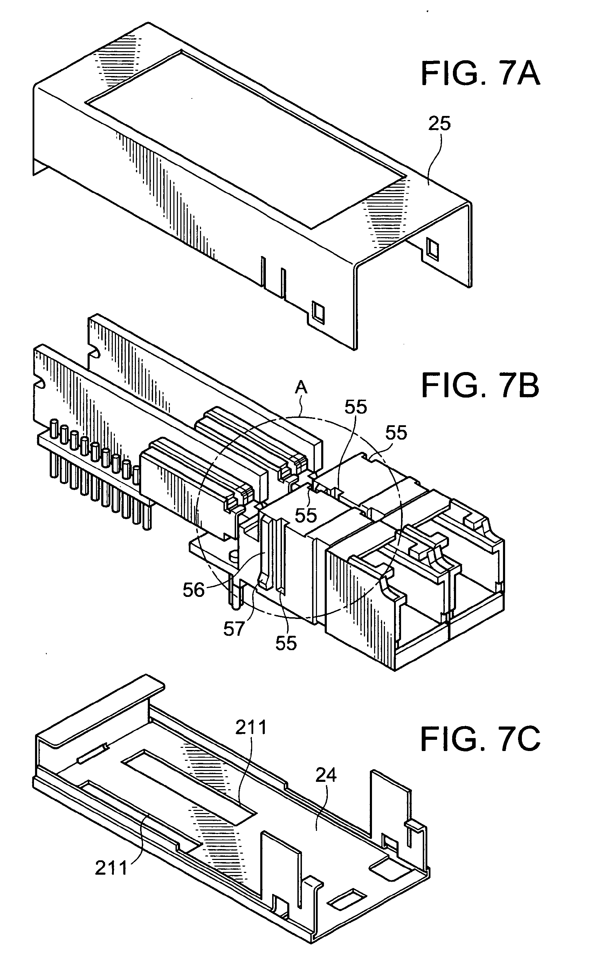

FIG. 6 is a perspective view of the SFF transceiver according to the exemplary embodiment of the present invention. FIGs. 7A to 7C form an exploded perspective view of the SFF transceiver shown in FIG. 6.

In FIGs. 7A to 7C, positioning concave parts 55 and positioning convex parts 56 are formed in respective bases 50 of the two optical units. The two optical units, in which the positioning convex part 56 of one of the optical units is positioned in the positioning concave part 55 of the other optical unit, are fixed by being sandwiched from above and below by a main cover 25 and a base cover 24. Thus, the SFF transceiver shown in FIG. 6 is formed. In a lower surface of the base cover 24, two connection terminal insertion holes 211 are formed. Connection terminals provided respectively in the two optical units are inserted in the two connection terminal insertion holes.

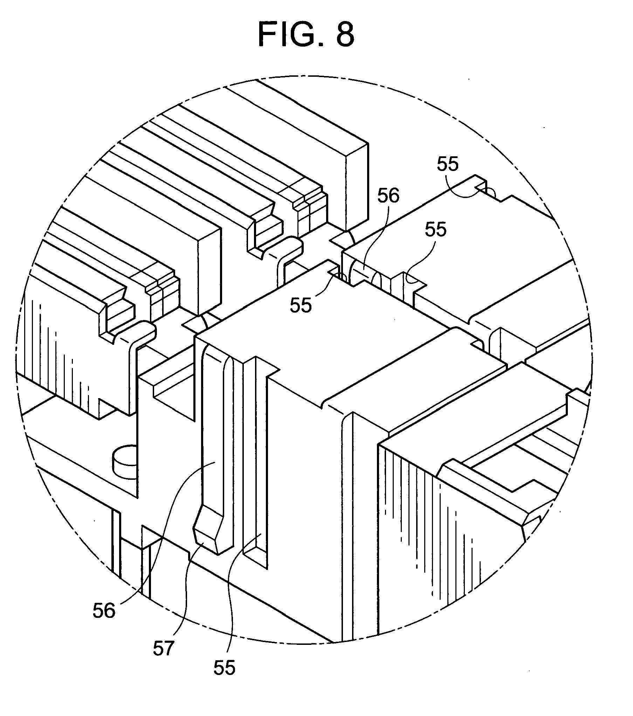

FIG. 8 is an enlarged view of the part A shown in FIGs. 7A to 7C.

In FIG. 8, the positioning concave parts 55 are substantially rectangular-shaped grooves formed in both sides of the base 50. And the positioning convex parts 56 are hill-shaped protrusions formed on both sides of the base 50. In one of the optical units, the positioning concave part 55 and the positioning convex part 56 which are formed on one of the sides of the base 50 are in a positional relationship opposite to that between the positioning concave part 55 and the positioning convex part 56 which are formed on the other side. Accordingly, the positioning concave part 55 and the positioning convex part 56 in one of the optical units are fitted into the positioning convex part 56 and the positioning concave part 55 in the other optical unit, respectively. Thus, the two optical units are connected to each other.

As described above, the SFF transceiver of this exemplary embodiment becomes a two-channel transceiver having the two optical units connected to each other.

Moreover, a width of the SFF transceiver of this exemplary embodiment, which is indicated by "C" in FIG. 6, is set at 13.59 mm, which is the same as that of the SFF transceiver specified by the industry standards MSA. That is, compared with a width of 14.7 mm (= 7.35 mm × 2) in a case where two SFF transceivers of the previous exemplary embodiment are arranged in parallel, the width is reduced by thicknesses of respective one sides of two cases. Note that, the width of the SFF transceiver of this embodiment can also be set smaller than 13.59 mm by various factors, for example, by reducing heights of electronic components mounted on the substrate 41 or by reducing the thickness of the substrate 41.

Moreover, although the SFF transceiver of this exemplary embodiment has the same size as that of the general SFF transceiver having only one optical unit, the SFF transceiver of this exemplary embodiment can realize functions of the two general SFF transceivers by having the two optical units. Thus, the SFF transceiver of this exemplary embodiment having the functions of the two general SFF transceivers can be mounted in a region for mounting one general SFF transceiver.

Furthermore, mounting of one SFF transceiver of this embodiment is equivalent to mounting of two general SFF transceivers. Thus, in a case where a large number of SFF transceivers are mounted on a master substrate, the number of mounting steps and costs can be significantly reduced.

Furthermore, a pitch between the receptacle 51 in the optical units adjacent to each other is equal to a pitch width specified by International Electrotechnical Commission (IEC). Thus, a multicore connector can be mounted.

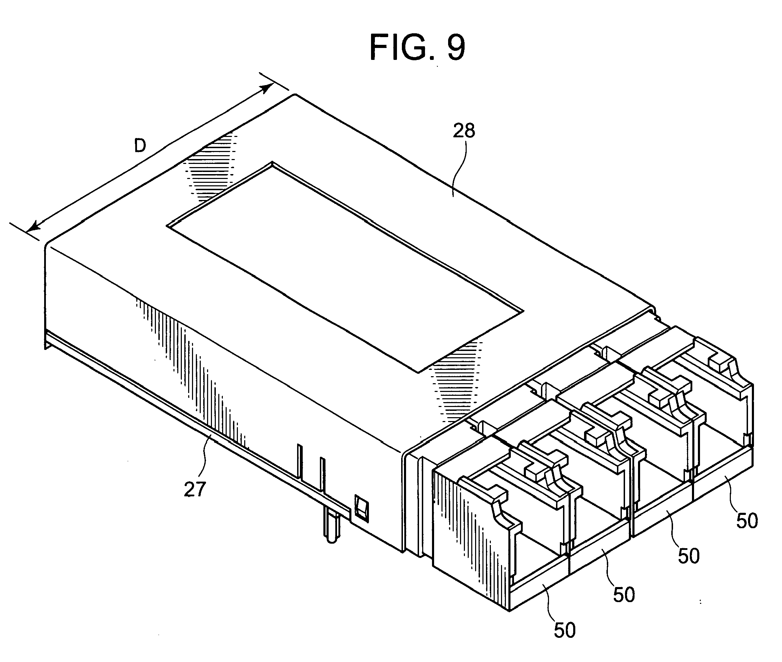

Next, another exemplary embodiment of the present invention will be described with reference to Figs. 9 to 10.

An SFF transceiver of this exemplary embodiment has four optical units of the previous exemplary embodiment.

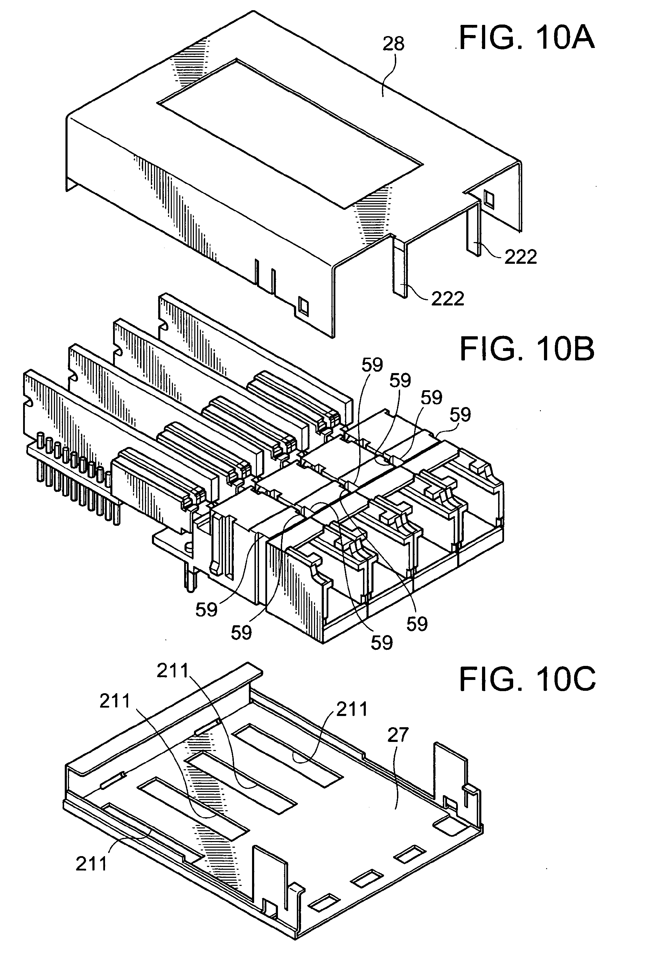

FIG. 9 is a perspective view of the SFF transceiver according to this exemplary embodiment of the present invention. FIGs. 10A to 10C form an exploded perspective view of the SFF transceiver shown in FIG 9.

In FIGs. 10A to 10C, four optical units connected by use of the same method as that of the previous exemplary embodiment are fixed by being sandwiched from above and below by a main cover 28 and a base cover 27. Thus, the SFF transceiver shown in FIG 9 is formed. In a base 50 in one of the optical units, optical unit reinforcing parts 59, which are substantially rectangular grooves, are formed in both sides thereof. When the optical unit is connected to the optical unit adjacent thereto, rectangular spaces are formed by the optical unit reinforcing parts 59 in the optical units adjacent to each other. Into the spaces, optical unit reinforcing parts 222 formed on one end of the main cover 28 are inserted. Thus, the optical units are fixed to each other. Note that, in a lower surface of the base cover 27, four connection terminal insertion holes 211 are formed, into which connection terminals provided in the four optical units, respectively, are inserted.

The SFF transceiver of the previous exemplary embodiment becomes a four-channel transceiver having the four optical units connected to each other.

Moreover, a width of the SFF transceiver of this embodiment, which is indicated by "D" in FIG 9, is set at 26.1 mm, which is smaller than a width of 27.18 mm (= 13.59 mm × 2) in a case where two SFF transceivers specified by the industry standards MSA are connected in parallel. Note that, the width of the SFF transceiver of this exemplary embodiment can also be set smaller than 26.1 mm by various factors, for example, by reducing heights of electronic components mounted on the substrate 41 or by reducing the thickness of the substrate 41.

For this reason, the SFF transceiver of this exemplary embodiment having functions of four general SFF transceivers can be mounted in a region for mounting two general SFF transceivers.

Furthermore, the mounting of one SFF transceiver of this exemplary embodiment is equivalent to mounting four general SFF transceivers. Thus, in a case where a number of SFF transceivers are mounted on a master substrate, the number of mounting steps and costs can be significantly reduced.

In the above of the exemplary embodiment of the present invention, as shown in FIG. 5, the substrate 41 is provided substantially perpendicular to the lower surface of the base cover 21, the upper surface of the main cover 22 or the master substrate 2, or is provided in parallel to the side of the main cover 22. However, for example, as shown in FIG 11, the substrate 41 may be positioned at a tilt. The tilting angle of the substrate 41 is arbitrary, and is, for example, at 30 degrees, 45 degrees or 60 degrees relative to the lower surface of the base cover 21, the upper surface of the main cover 22 or the master substrate 2. It is only necessary that the substrate 41 not be parallel to the lower surface of the base cover 21. As described above, by tilting the substrate 41 at a predetermined angle, the area of the substrate 41 on which electronic components are mounted can be increased compared with a case where the substrate 41 is parallel to the lower surface of the base cover 21. Particularly, as shown in FIG. 11, the substrate 41 may be positioned on a plane including at least a first side, which forms the upper surface of the main cover 22, and a second side, which forms the lower surface of the base cover 21, in other words, on a diagonal line of the case in the cross-sectional view of the case, since the area of the substrate 41 is maximized.

Moreover, according to an exemplary embodiment of the present invention, the two- or four-channel SFF transceiver including the two or four optical units are mentioned. However, the present invention is not limited thereto. For example, the present invention can also be applied to a five-, six- or seven-channel SFF transceiver including five, six or seven optical units, and the like. Furthermore, according to an exemplary embodiment of the present invention, the SFF transceiver has been described as an example of the optical transceiver. However, the present invention is not limited thereto. For example, the present invention can also be applied to various optical transceivers such as a small form-factor pluggable (SFP) transceiver and a 10 gigabit small form-factor pluggable (XFP) transceiver.

While exemplary embodiments of the present invention have been described above, it is to be understood that further numerous modifications to the exemplary embodiments of the invention will be apparent to those skilled in the art without departing from the spirit and scope of the present invention, as defined in the following claims and their legal equivalents.

## Claims

1. An optical transceiver comprising:
a substrate having at least one electronic component mounted thereon;
a base comprising a receptacle for connecting to an optical connector; and
a case housing said substrate and at least a part of said base.

2. The optical transceiver according to claim 1, wherein said substrate is not mounted on said base.

3. The optical transceiver according to claim 1,
wherein said case comprises an upper surface and a lower surface, and
wherein said base contacts with the upper and lower surfaces of said case.

4. The optical transceiver according to one of claim 1, wherein said substrate is positioned at substantially perpendicular to at least one of the upper surface and the lower surface of said case.

5. The optical transceiver according to claim 1, further comprising:
a connection terminal connected to said substrate,
wherein said connection terminal is not inserted in said base.

6. The optical transceiver according to claim 1, wherein said base comprises a first material and said case comprises a second material different from said first material.

7. An optical transceiver comprising:
a substrate having at least one electronic component mounted thereon;
a base comprising a receptacle for connecting an optical connector; and
a case, housing said substrate, said case comprising at least an upper surface and a lower surface,
wherein said substrate is not parallel to one of the upper surface and the lower surface of said case.

8. The optical transceiver according to claim 7, wherein said substrate is not mounted on said base.

9. The optical transceiver according to claim 7, wherein said base contacts with the upper and lower surfaces of said case.

10. The optical transceiver according to one of claim 7, wherein said substrate is substantially perpendicular to at least one of the upper surface and the lower surface of said case.

11. The optical transceiver according to claim 7, wherein said substrate comprises an upper edge in contact with said upper surface of said case and a lower edge in contact with said lower surface of said case.

12. The optical transceiver according to claim 7, further comprising:
a connection terminal connected to said substrate,
wherein said connection terminal is not inserted in said base..

13. The optical transceiver according to claim 7, wherein said base comprises a first material and said case comprises a second material, different from said first material.

14. An optical transceiver comprising:
a substrate comprising at least one electronic component mounted thereon;
a base, having a first end and a second end, opposite the first end, and having a first side and a second side opposite the first side, the base comprising
a groove formed in the first end,
a receptacle for connecting an optical connector formed in the second end ,
a locking protrusion formed on the first side, and
a locking protrusion formed on the second side; and
a case having a first side and a second side, opposite the first side, and an upper surface and a lower surface, the case comprising
at least one locking hole formed in the first side and
at least one locking hole formed in the second side,
wherein the case houses at least said substrate and a part of said base,
wherein said substrate is positioned substantially perpendicular to at least one of the upper surface and the lower surface of said case,
wherein an end of said substrate is held in said groove in said base, and
wherein said locking protrusions of said base are disposed in said locking holes of said case.

15. The optical transceiver according to claim 14, wherein said substrate is not mounted on said base.

16. The optical transceiver according to claim 14, wherein said base contacts with the upper and lower surfaces of said case.

17. The optical transceiver according to claim 14, further comprising:
a connection terminal connected to said substrate,
wherein said connection terminal is not inserted in said base.

18. The optical transceiver according to claim 14, wherein said base comprises a first material and said case comprises a second material, different form the first material.

19. The optical transceiver according to claim 18, wherein said first material is resin, and said second material is metal.

20. An optical transceiver comprising:
a plurality of optical units each of which comprise:
a base comprising sides having concave and convex portions therein, and
a substrate comprising at least one electronic component mounted thereon, wherein said substrate is fixed to an end of said base; and
a case having an upper surface and a lower surface, said case housing at least each of said substrates and a part of each of said bases,
wherein each of said substrates is substantially perpendicular to at least one of the upper surface and the lower surface of the case, and
wherein the concave and convex portions of a base fit with the convex and concave portions of an adjacent base such that the plurality of optical units are connected to one another thereby.

21. The optical transceiver according to claim 20, wherein
at least one base comprises a groove on a side thereof, and said case comprises at least one reinforcing part which is inserted in said groove.
